# EUROPEAN PATENT APPLICATION

(11) **EP 4 653 387 A1**
(43) Date of publication of application: **26.11.2025**
(21) Application number: 24177911.5
(22) Date of filing: 24.05.2024
(51) Int. Cl.: B81C 1/00

(54) **A COMPONENT WITH IMPROVED ADHESIVE BLEED-OUT CLEARANCE**

(71) Applicant: Murata Manufacturing Co., Ltd., Nagaokakyo-shi, Kyoto 617-8555 (JP)
(72) Inventor: Kaija, Kimmo, 02660 Espoo (FI); Nurmi, Sami, 04320 Tuusula (FI); Syrjänen, Teppo, 00400 Helsinki (FI)
(74) Representative: Boco IP Oy Ab

(57) **Abstract**

The disclosure is based on the idea of reducing the span length of a MEMS die which is attached to the top of an ASIC die via an adhesive layer by applying a step cut on the bottom of the MEMS die. This improves the clearance between the MEMS die and bonding pads attached to the top of the ASIC die, thereby preventing failures of electrical connections between the MEMS die and the ASIC die.

## Description

### FIELD OF THE DISCLOSURE

This disclosure relates to microelectromechanical devices and more particularly to MEMS die bonding via adhesives. The present disclosure further concerns MEMS backside surface shaping.

### BACKGROUND OF THE DISCLOSURE

Electronic chips, which may also be called dies, are usually prepared by manufacturing various electronic structures on a substrate and cutting the substrate into small, chip-size pieces. These dies may be MEMS (microelectromechanical systems) dies or ASIC (Application-Specific Integrated Circuit) dies formed from/on a silicon wafer by semiconductor manufacturing technologies. ASIC dies typically contain electric circuitry which controls the operation of the MEMS device in the MEMS die.

An electronic component may comprise several dies where each die is mechanically attached to a substrate or to another die thereby forming a stack. The stack may be formed using an adhesive layer between the dies. Electrical connections are after that created for signal transmission and communication between the different dies within the component or between the dies and the substrate. These signals can carry information, data, or control signals necessary for the operation of the component.

Wire bonding is a method used to make electrical connections between various dies within an electrical component and/or external circuitry. It is widely used in MEMS fabrication and assembly as it allows for reliable electrical connections to be made in a compact and efficient manner. The method involves the placement of a conductive wire between a bonding pad on one die and the substrate or another die. The wire is then bonded to the bonding pad and the other die or the substrate. This bonding process typically involves applying heat, pressure, and/or ultrasonic energy to create a strong and reliable electrical connection between the wire and the bonding pads.

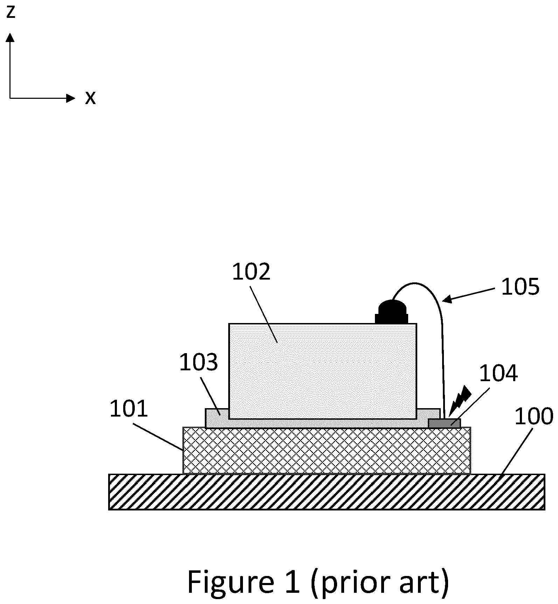

When an adhesive layer is used to stack a MEMS die on another die, such as an ASIC die, MEMS stacking is limited by the distance between the MEMS die and the bonding pad on the ASIC die. Figure 1 illustrates an electronic component from the prior art comprising a MEMS die 102 and the ASIC die 101 stacked on a substrate 100. The MEMS die 102 is attached on the ASIC die 101 using an adhesive layer 103. The dies are electrically connected to each other via a wire bond 105. In this example, there is insufficient clearance between the MEMS die 102 and the bonding pad 104 on the ASIC die 101 causing the adhesive layer to spread over the ASIC pad 104, resulting in failed wire bonding. Previous solutions to this problem included MEMS size reduction, ASIC size increase or the use of expensive Die Attach Film (DAF) adhesive.

Document US20190043823A1 discloses a negative fillet for mounting an integrated device die to a carrier.

### BRIEF DESCRIPTION OF THE DISCLOSURE

An object of the present disclosure is to provide a solution to the problem described above.

The disclosed solution allows improved clearance for adhesive spread in electronic components comprising at least one MEMS die attached to an ASIC die via an adhesive layer. Examples provided in this disclosure describe ways to implement the solution.

The object of the disclosure is achieved by an arrangement and a fabrication method which are characterized by what is stated in the independent claims. The preferred embodiments of the disclosure are disclosed in the dependent claims.

The disclosure is based on the idea of reducing the span length of the MEMS die, which is electrically connected to the ASIC die via a wire bond, by applying a step cut on the bottom of the MEMS die. An advantage of the disclosure is that the clearance between the MEMS die and the bonding pad on the ASIC die is improved while MEMS size shrinkage, ASIC size increase or use of expensive DAF adhesive are avoided. This provides improvements in wire bonding reliability.

### BRIEF DESCRIPTION OF THE DRAWINGS

In the following, the disclosure will be described in greater detail by means of preferred embodiments with reference to the accompanying drawings, in which
Figure 1 illustrates an electronic component from the prior art comprising a MEMS die attached to an ASIC die via an adhesive layer. The adhesive layer spreads to the bonding pad;
Figure 2a illustrates a side view of a MEMS die in accordance with one embodiment of the invention;
Figure 2b illustrates an electronic component comprising the MEMS die shown in figure 2a;
Figure 3a illustrates a side view of a MEMS die in accordance with another embodiment of the invention;
Figure 3b illustrates an electronic component comprising the MEMS die shown in figure 3a;
Figures 4a-c illustrate examples of possible shapes of the non-horizontal surface of the bottom part;
Figure 5a illustrates a three-dimensional view of a MEMS die in accordance with one embodiment of the invention. The non-horizontal surface of the bottom part comprises a plurality of tilted faces;
Figure 5b illustrates a side view of the MEMS die in figure 5a;
Figure 6a illustrates a three-dimensional view of a MEMS die in accordance with another embodiment of the invention. The non-horizontal surface of the bottom part comprises a plurality of faces;
Figure 6b illustrates a side view of the MEMS die in figure 6a;
Figure 7a illustrates a three-dimensional view of a MEMS die wherein the non-horizontal surface of the bottom part is curved;
Figure 7b illustrates a side view of the MEMS die in figure 7a;
Figure 8a illustrates a three-dimensional view of a MEMS die wherein the bottom part comprises a plurality of horizontal surfaces;
Figure 8b illustrates a side view of the MEMS die in figure 8a;
Figures 8c-d illustrate examples of electronic components comprising the MEMS die shown in figure 8a;
Figure 9 illustrates an electronic component comprising a MEMS die and an ASIC die. The ASIC die is attached to substrate via an additional adhesive layer;
Figures 10a-b illustrate examples of electronic components comprising a MEMS die and an ASIC die. The ASIC die is wire bonded to the substrate;
Figures 11a-g illustrate an example method for the fabrication of an electronic component comprising a MEMS die stacked onto an ASIC die;

### DETAILED DESCRIPTION OF THE DISCLOSURE

The disclosure describes an electronic component comprising a substrate with a top side and a bottom side. The substrate defines a horizontal xy-plane and a vertical z-direction which is perpendicular to the xy-plane. The electronic component further comprises an ASIC die. The ASIC die has a top side and a bottom side, and the bottom side of the ASIC die is attached to the top side of the substrate.

The electronic component further comprises a MEMS die wherein the MEMS die comprises a top part and a bottom part. The bottom part comprises at least one horizontal surface and at least one non-horizontal surface. The horizontal surface defines at least a portion the bottom surface of the MEMS die. The top part and the bottom part of the MEMS die are contiguous with each other and are aligned along the z-direction so that the non-horizontal surface extends between the horizontal surface of the bottom part and top part.

The component further comprises an adhesive layer. The adhesive layer extends in the z-direction from the top side of the ASIC die to the horizontal surface and to a portion of the non-horizontal surface of the bottom part of the MEMS die. The component further comprises a bonding pad and an electrical connection. The bonding pad is attached to the top side of the ASIC die next to the adhesive layer, and the electrical connection extends from the bonding pad to the top of the MEMS die.

The component is intended to be mounted, for example onto an external object. That external object could be oriented in any manner. Any direction or plane which is parallel to the xy-plane defined by the substrate can be called horizontal. The direction which is perpendicular to the xy-plane can be called the vertical direction. Expressions such as "top", "bottom", "above", "below", "up" and "down" refer in this disclosure to differences in the vertical z-coordinate. These expressions do not imply anything about how the device should be oriented with respect to the Earth's gravitational field when the component is in use or when it is being manufactured.

In an implementation form, the top part of the MEMS die may comprise a horizontal bottom. The non-horizontal surface of the bottom part may extend from the horizontal surface of the bottom part to the horizontal bottom of the top part.

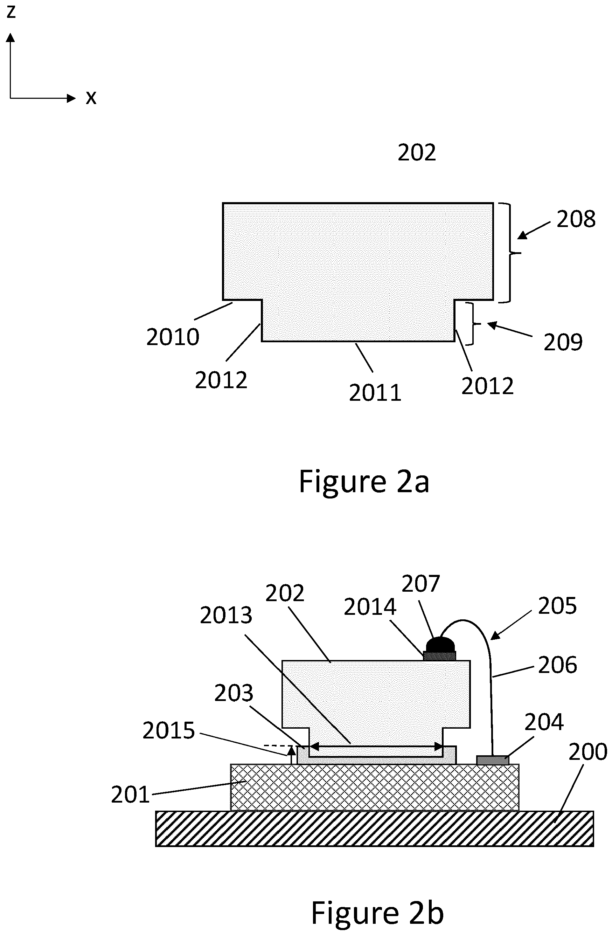

Figure 2a illustrates an example of a side view of a MEMS die 202. The MEMS die 202 comprises a top part 208 and a bottom part 209 which are contiguous with each other and are aligned along the z-direction. In this example, the top part 208 protrudes in the x-direction beyond the bottom part 209. The bottom part 209 of the MEMS die comprises a horizontal surface 2011 which is parallel to the xy-plane. The horizontal surface 2011 defines the bottom surface of the MEMS die 202. The bottom part 209 of the MEMS die further comprises a non-horizontal surface 2012. In this example, the non-horizontal surface 2012 is vertical, and the xy cross-section of the bottom part 209 of the MEMS die may have a square, a rectangular, or circular shape. The top part 208 of the MEMS die comprises a horizontal bottom 2010 which is parallel to the horizontal surface of the bottom part 2011. The vertical surface of the bottom part 2012 extends from the horizontal surface 2011 of the bottom part to the horizontal bottom 2010 of the top part.

Figure 2b illustrates an electronic component comprising the MEMS die 202 shown in figure 2a. The electronic component further comprises a substrate 200 with a top side and a bottom side, and an ASIC die 201. The ASIC 201 die has a top side and a bottom side, and the bottom side of the ASIC die is attached to the top side of the substrate. The MEMS die 202 is attached to the top side of the ASIC die 201 via an adhesive layer 203. The adhesive layer 203 extends in the z-direction from the top side of the ASIC die 201 to the horizontal surface 2011 and to a portion of the non-horizontal surface 2012 of the bottom part of the MEMS die 202. In other words, the adhesive fillet extends in the z-direction along a portion of the non-horizontal surface 2012 of the bottom part 209 without reaching the top part 208 of the MEMS die. This applies to all embodiments presented in this disclosure.

The term "adhesive fillet" refers to the ridge of adhesive material that forms beyond the boundaries of the horizontal surface 2011 of the bottom part 209 when the MEMS die 202 is glued to the top surface of the ASIC die 201. The component further comprises a bonding pad 204 and an electrical connection 205. The bonding pad 204 is attached to the top side of the ASIC die 201 next to the adhesive layer 203, and the electrical connection 205 extends from the bonding pad 204 to the top of the MEMS die 202. The electrical connection 205 may comprise a bonding wire 206 and bond ball 207 so that bonding wire 206 extends from the bonding pad 204 to the bond ball 207. The bond ball 207 may be attached to an additional bonding pad 2014 located on the top surface of the MEMS die 202.

The adhesive fillet height is less than the non-horizontal surface height in the z-direction. In other words, the adhesive fillet, which is formed when stacking the MEMS die and the ASIC die together, does not come in touch with the top part of the MEMS die. The adhesive fillet may extend in the z-direction along less than a 1/5, 1/4, 1/3, 1/2, or 3/4 of the non-horizontal surface height. The adhesive fillet height 2015 may be in the range of [5-200] µm, [5-250] µm, [50-200] µm, [100-200] µm, or [100-150] µm. These options may apply to any embodiment in this disclosure. The term "span length of the MEMS die" refers to the length of the bottom part 209 in the x-direction at the z-coordinate corresponding to the adhesive fillet height 2015. This applies to any embodiment in this disclosure. The span length 2013 of the MEMS die is less than the smallest distance in the x-direction between two points on opposite sides of the top part. This ensures wire bond reliability by preventing the adhesive fillet from reaching the bonding pad while avoiding the reduction of the MEMS die size or the increase of the ASIC die size.

The MEMS die 202 may be a MEMS sensor. The MEMS sensor may be an accelerometer or a gyroscope. The ASIC die 201 may be a sensor interface ASIC, an actuator drive ASIC, a mixed-signal ASIC, a system-on-chip (SoC) ASIC, a wireless ASIC, or a Custom ASIC. These options may apply to any embodiment in this disclosure.

The adhesive layer 203 may comprise a liquid adhesive such as epoxy resin, cyanoacrylate adhesives, anaerobic adhesives, UV curable adhesives, silicone-based adhesives, or conductive adhesives. The bonding wire 206 may be made of conductive material. It may be made of a variety of metals that include but are not limited to Cu, Ni, Al, Ag, Au, Pt, Pd, Mo or metal alloys. The substrate 200 may be a 1^{st}-level substrate. The term "1^{st}-level substrate" refers to the package internal substrate on which dies are assembled first. It may comprise BT-epoxy, FR-laminate, a copper lead-frame, polyimide substrate, etc. Alternatively, the substrate may comprise a printed circuit board (PCB) such as FR-1, FR-2, FR-3, FR-4, FR-5, CEM, LTCC, or a flexible PCB. These options may apply to any embodiment in this disclosure.

In another implementation form, the top part of the MEMS die may comprise a side wall, wherein the non-horizontal surface of the bottom part extends from the horizontal surface of the bottom part to the side wall of the top part.

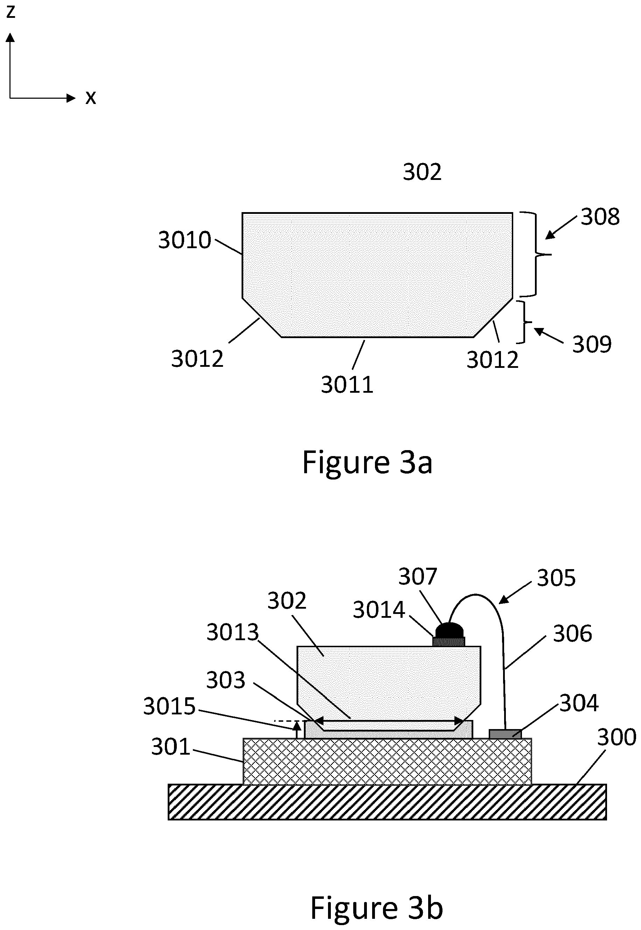

Figure 3a illustrates another example of a side view of a MEMS die 302. The MEMS die 302 comprises a top part 308 and a bottom part 309 which are contiguous with each other and are aligned along the z-direction. In this example, the top part 308 comprises a side wall 3010. The bottom part 309 of the MEMS die comprises a horizontal surface 3011 which defines the bottom surface of the MEMS die 302. The bottom part 309 of the MEMS die further comprises a non-horizontal surface 3012. The non-horizontal surface 3012 of the bottom part extends from the horizontal surface 3011 of the bottom part to the side wall 3010 of the top part. In this example, the non-horizontal surface 3012 is tilted in relation to the horizontal surface 3011.

Figure 3b illustrates an electronic component comprising the MEMS die 302 shown in figure 3a. The electronic component further comprises a substrate 300 and an ASIC die 301. The bottom side of the ASIC die 301 is attached to the top side of the substrate 300. The MEMS die 302 is attached to the top surface of the ASIC die 301 using an adhesive layer 303. The adhesive layer 303 extends in the z-direction from the top side of the ASIC die 301 to the horizontal surface 3011 and to a portion of the non-horizontal surface 3012 of the bottom part of the MEMS die. In other words, the adhesive fillet which is formed when stacking the MEMS die 302 and the ASIC die 303 together does not come in touch with the top part 308 of the MEMS die 302. This applies to all embodiments presented in this disclosure.

The span length 3013 of the MEMS die is less than the smallest distance in the x-direction between two points on opposite sides of the top part 308. Reference numbers 304, 305, 306, 307, 3014 and 3015 in figure 3b correspond to reference numbers 204, 205, 206, 207, 2014 and 2015, respectively, in figure 2b.

The xy cross-section of the bottom part of the MEMS die may have a circular shape or a polygon shape such as triangle, quadrilaterals (square, rectangle, parallelogram, rhombus, trapezoid, etc.), pentagons, hexagons, etc. These options may apply to any embodiment in this disclosure. The non-horizontal surface of the bottom part may comprise a plurality of faces wherein the angle in the xy-plane between at least one pair of adjacent faces is a right angle. In other words, the angle formed between these adjacent faces is a 90° angle. Alternatively, the non-horizontal surface of the bottom part may comprise a plurality of faces wherein the angle in the xy-plane between at least one pair of adjacent faces is a non-right angle. The angle in the xy-plane between the at least one pair of adjacent faces may be an acute angle, or the angle in the xy-plane between the at least one pair of adjacent faces may be an obtuse angle.

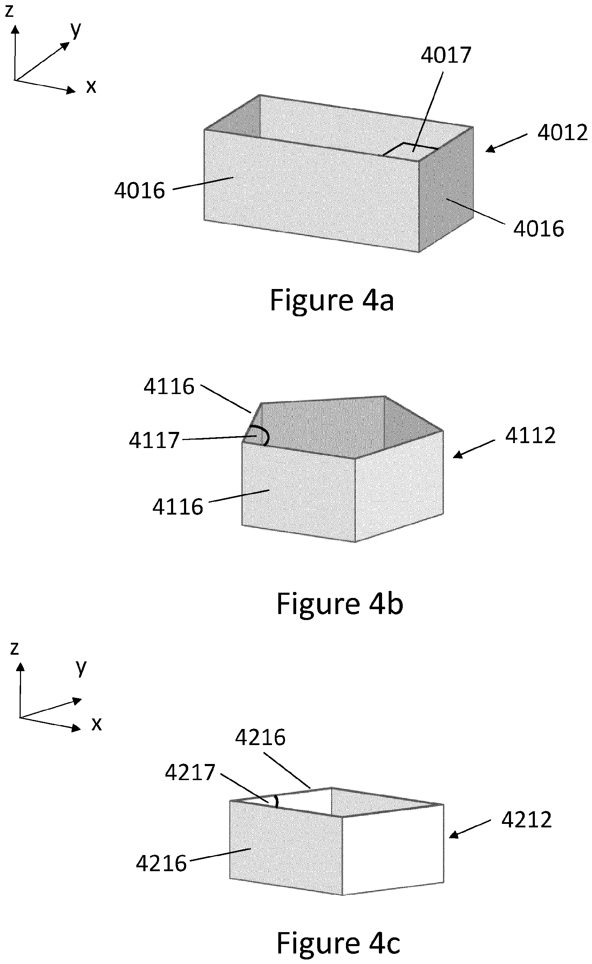

Figures 4a-c illustrate examples of possible shapes of the non-horizontal surface of the bottom part. In figure 4a, the non-horizontal surface 4012 of the bottom part has four vertical faces 4016, and the angle in the xy-plane 4017 between each pair of adjacent faces is a right angle. In other words, the faces 4016 of the non-horizontal surface 4012 are arranged in a three-dimensional shape where every two meeting faces form an interior angle of 90°. In this example, the xy cross-section of the bottom part has a rectangular shape.

In figure 4b, the non-horizontal surface 4112 of the bottom part has five vertical faces 4116, and the angle in the xy-plane 4117 between each pair of adjacent faces is an obtuse angle. The xy cross-section of the bottom part has a pentagon shape and every two meeting faces 4116 of the non-horizontal surface 4112 form an interior angle of 108°.

In figure 4c, the non-horizontal surface 4212 of the bottom part has four vertical faces 4216. The vertical faces 4216 are arranged in a three-dimensional shape where they form in the xy-plane four interior non-right angles 4217. The xy cross-section of the bottom part has a parallelogram shape with two interior acute angles and two interior obtuse angles.

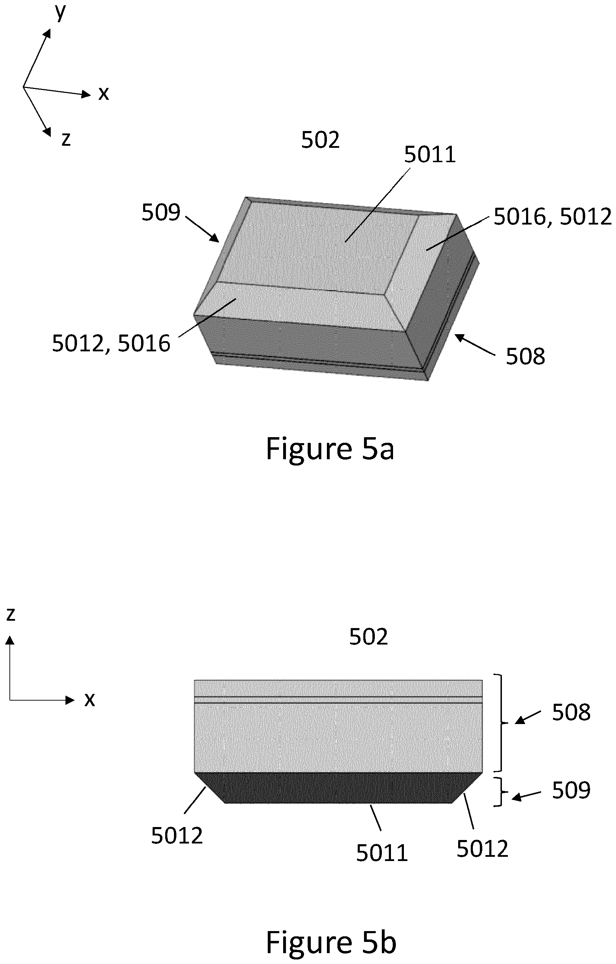

Figure 5a illustrates a three-dimensional view of a MEMS die 502 in accordance with one embodiment of the invention. Figure 5b illustrates a side view of the MEMS die 502 shown in figure 5a. The MEMS die 502 comprises a top part 508 and a bottom part 509. The bottom part 509 of the MEMS die comprises a horizontal surface 5011 and a non-horizontal surface 5012. In this example, the horizontal surface 5011 and the non-horizontal surface 5012 form a symmetric truncated square pyramid shape. The non-horizontal surface 5012 of the bottom part 509 comprises four slanted faces 5016.

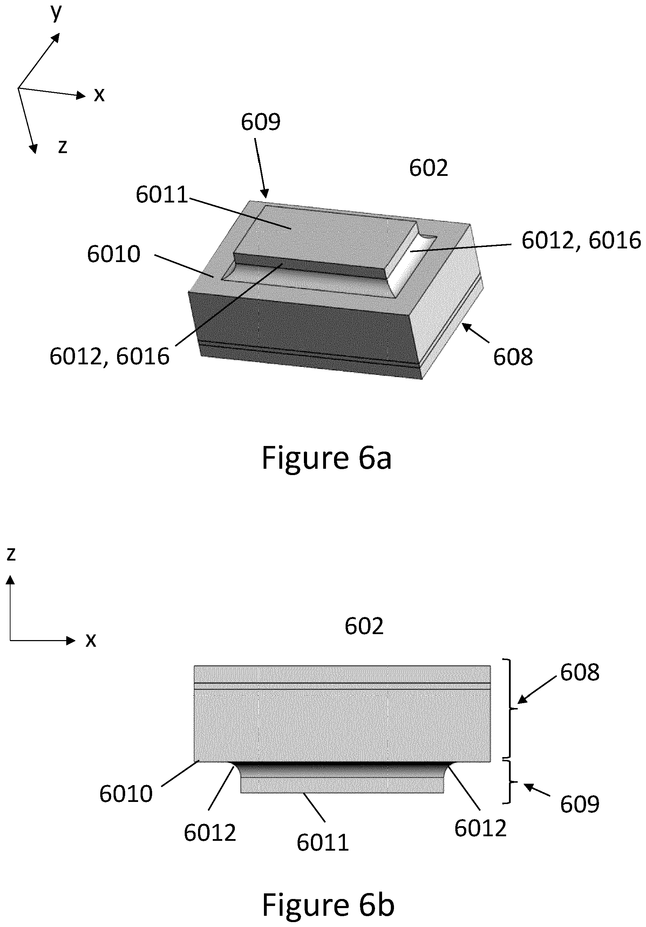

Figure 6a illustrates a three-dimensional view of a MEMS die 602 in accordance with another embodiment of the invention. Figure 6b illustrates a side view of the MEMS die 602 shown in figure 6a. The MEMS die 602 comprises a top part 608 and a bottom part 609. The bottom part 609 of the MEMS die comprises a horizontal surface 6011 and a non-horizontal surface 6012. In this example, the top part 608 of the MEMS die comprises a horizontal bottom 6010 which is parallel to the horizontal surface of the bottom part 6011. The non-horizontal surface 6012 of the bottom part 609 comprises four side faces 6016. Each side face comprises a vertical portion and a curved portion. The curved portions extend between the vertical portions of the non-horizontal surface and the horizontal bottom of the top part 6010.

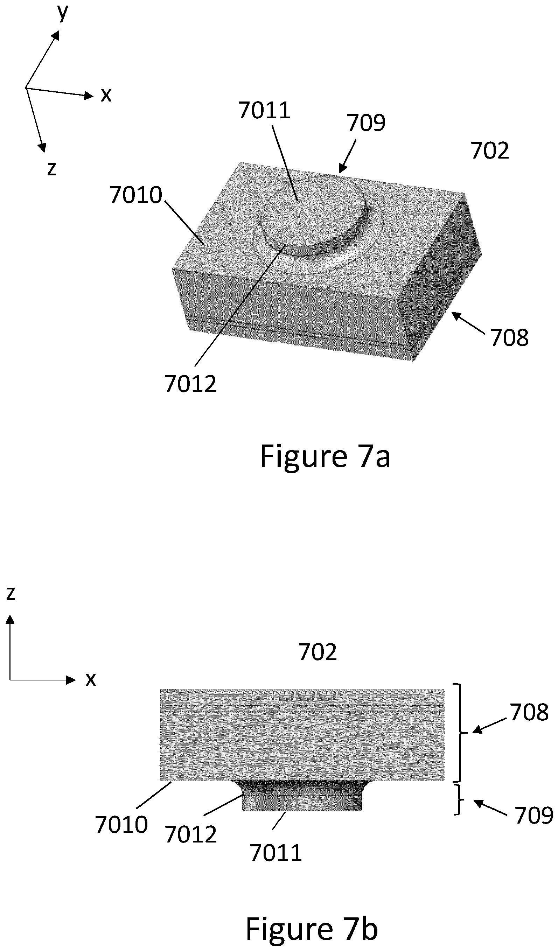

Alternatively, the non-horizontal surface of the bottom part may be curved. Figure 7a illustrates a three-dimensional view of a MEMS die 702 in accordance with another embodiment of the invention. Figure 7b illustrates a side view of the MEMS die 702 shown in figure 7a. The MEMS die 702 comprises a top part 708 and a bottom part 709. The bottom part 709 of the MEMS die comprises a horizontal surface 7011 and a non-horizontal surface 7012. In this example, the top part of the MEMS die 708 comprises a horizontal bottom 7010 which is parallel to the horizontal surface 7011 of the bottom part. The non-horizontal surface 7012 of the bottom part 709 has the shape of a column's lateral surface. In other words, the non-horizontal surface 7012 of the bottom part is a curved surface without any edges or corners. The non-horizontal surface 7012 of the bottom part extends between the horizontal surface 7011 of the bottom part and the horizontal bottom 7010 of the top part 708 of the MEMS die.

The bottom part may comprise a plurality of horizontal surfaces. The horizontal surfaces may be separated by trenches wherein the adhesive layer further extends in the z-direction from the top side of the ASIC die through the trenches.

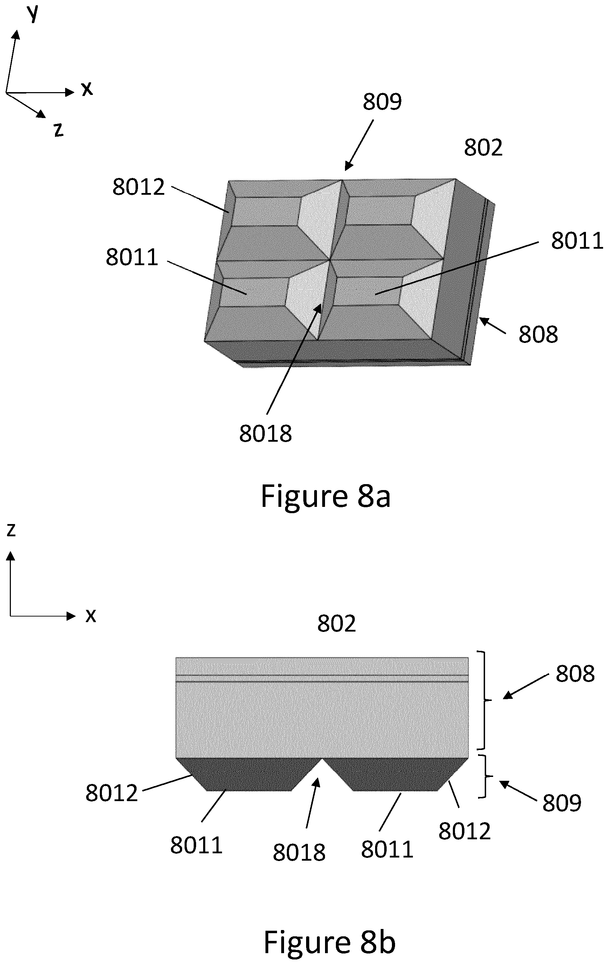

Figure 8a illustrates a three-dimensional view of a MEMS die 802 comprising trenches. Figure 8b illustrates a side view of the MEMS die shown in figure 8a. The MEMS die 802 comprises a top part 808 and a bottom part 809. The bottom part 809 of the MEMS die comprises a non-horizontal surface 8012 and a plurality of horizontal surfaces 8011. The bottom part of the MEMS die 809 further comprises trenches 8018 located between the horizontal surfaces 8011 of the bottom part. The trenches are narrow channels extending in the z-direction. They may have different shapes such as rectangular shape, V-shape, U-shape, trapezoidal or irregular shape. These options may apply to any embodiment in this disclosure. In this example, the trenches 8018 have a V-shape.

The adhesive layer may extend in the z-direction from the top side of the ASIC die through the whole trench. Alternatively, the adhesive layer may extend in the z-direction from the top side of the ASIC die through a portion of the trench. These options may apply to any embodiment in this disclosure.

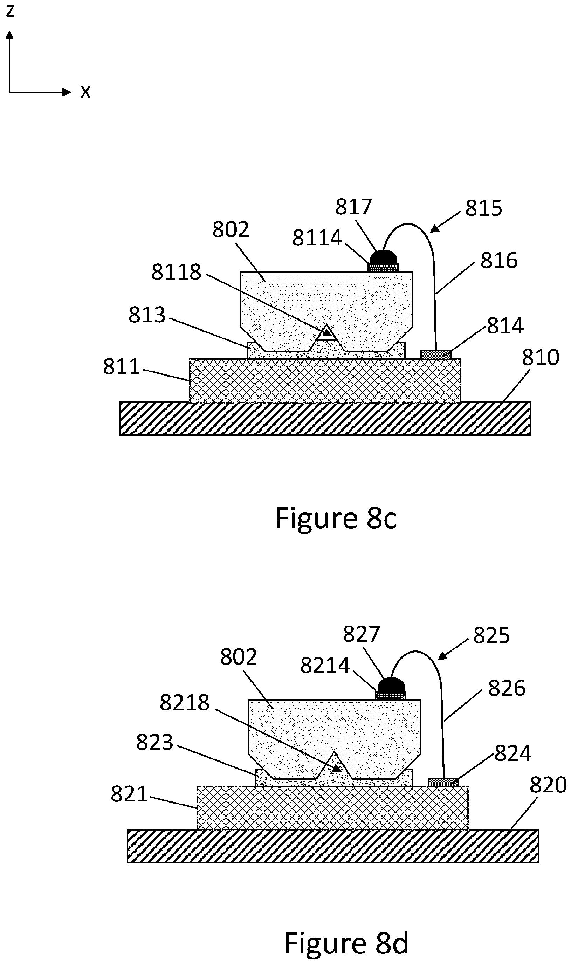

Figure 8c illustrates an example of an electronic component comprising the MEMS die 802 shown in figure 8a. The electronic component comprises a substrate 810 with a top side and a bottom side, and an ASIC die 811. The ASIC die 811 has a top side and a bottom side, and the bottom side of the ASIC die 811 is attached to the top side of the substrate 810. The MEMS die 802 is attached to the top side of the ASIC die 811 via an adhesive layer 813. The adhesive layer 813 extends in the z-direction from the top side of the ASIC die 811 to the horizontal surface 8011 and to a portion of the non-horizontal surface 8012 of the bottom part 809 of the MEMS die 802. In this example, the adhesive layer 813 further extends in the z-direction from the top side of the ASIC die 811 through a portion of the trenches 8118. Reference numbers 814, 815, 816, 817, and 8114 in figure 8c correspond to reference numbers 204, 205, 206, 707, and 2014, respectively, in figure 2b.

Figures 8d illustrates another example of an electronic component comprising the MEMS die 802 shown in figure 8a. In this example, the adhesive layer 823 extends in the z-direction from the top side of the ASIC die 821 through the whole trench 8218. Reference numbers 820, 824, 825, 826, 827, and 8214 in figure 8d correspond to reference numbers 200, 204, 205, 206, 207, and 2014, respectively, in figure 2b.

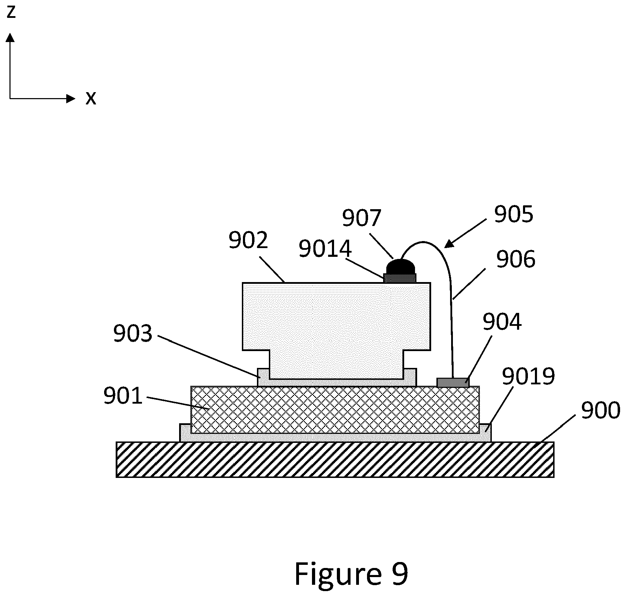

The ASIC die may be attached to the top of the substrate via an additional adhesive layer. Figure 9 illustrates an example of an electronic component comprising a MEMS die and an ASIC die. The MEMS die 902 is attached to the top side of the ASIC die 901 via an adhesive layer 903. The bottom side of the ASIC die 901 is attached to the top side of the substrate 900 via an additional adhesive layer 9019. The additional adhesive layer 9019 may comprise epoxy resin, cyanoacrylate adhesives, anaerobic adhesives, UV curable adhesives, silicone-based adhesives, conductive adhesives, or film adhesives. These options may apply to any embodiment in this disclosure. Reference numbers 904, 905, 906, 907 and 9014 in figure 9 correspond to reference numbers 204, 205, 206, 207 and 2014, respectively, in figure 2b.

The ASIC die may be electrically connected to the substrate. The electrical connection may comprise a bonding wire extending directly from the bonding pad to the top of the MEMS die, wherein the MEMS die is electrically coupled to the ASIC die via the bonding wire. Alternatively, the electrical connection may further comprise wiring layers in the substrate so that the MEMS die is electrically coupled to the ASIC die via the substrate. These options may apply to any embodiment in this disclosure.

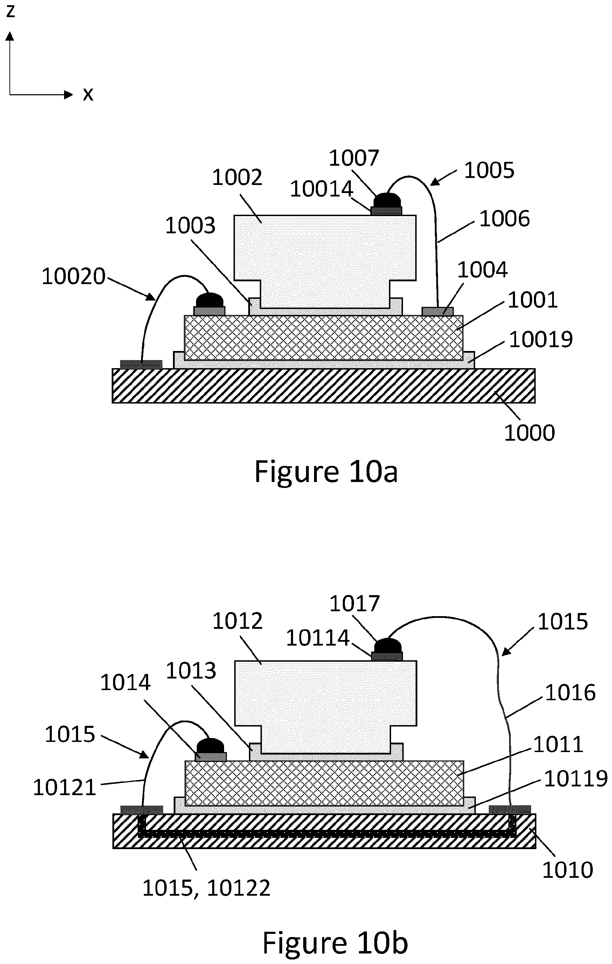

Figure 10a illustrates an example of an electronic component comprising a MEMS die 1002 and an ASIC die 1001. In this example, the ASIC die 1001 is wire bonded to the substrate 1000 via an additional connection 10020. The electrical connection 1005 comprise a bonding wire 1006 extending directly from the bonding pad 1004 to the top of the MEMS die 1002. The MEMS die 1002 is electrically coupled to the ASIC die 1001 via the bonding wire 1006. Reference numbers 1003, 1007 and 10014 in figure 10a correspond to reference numbers 203, 207, and 2014, respectively, in figure 2b. Reference number 10019 in figure 10a corresponds to reference number 9019 in figure 9.

Figure 10b illustrates another example of an electronic component comprising a MEMS die 1012 and an ASIC die 1011. In this example, the electrical connection 1015 comprises a bonding wire 1016, an additional bonding wire 10121 and a wiring layer 10122 located in the substrate 1010. The bonding wire 1016 extends from the wiring layer 10122 to the top of the MEMS die 1012, and the additional bonding wire 10121 extends from the wiring layer 10122 to the bonding pad 1014 located on the top side of the ASIC die 1011. In other words, the wiring layer 10122 in the substrate 1010 electrically connects the bonding wire 1016 to the additional bonding wire 10121, so that the MEMS die 1012 is electrically coupled to the ASIC die 1011. Reference numbers 1013, 1017 and 10114 in figure 10b correspond to reference numbers 203, 207, and 2014, respectively, in figure 2b. Reference number 10119 in figure 10b corresponds to reference number 9019 in figure 9.

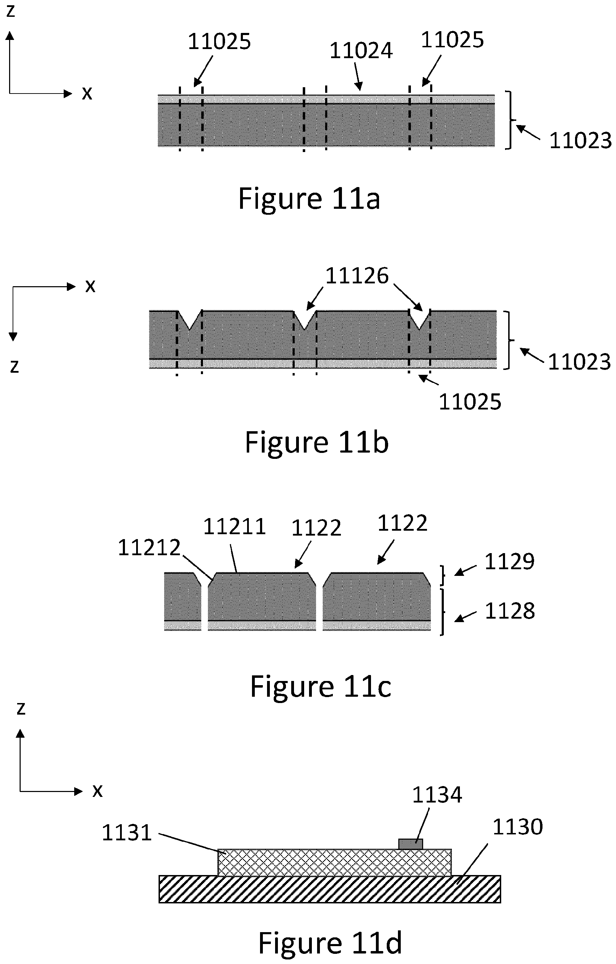

Figures 11a-g illustrate an example method for the fabrication of an electronic component comprising a MEMS die attached to the top side of an ASIC die using an adhesive layer. The method for manufacturing the electronic component comprises: (1) providing a wafer. The wafer has a top side and a bottom side, and the wafer comprises a device region and a dicing region. The dicing region surrounds the device region in the xy-plane. The wafer further comprises at least one MEMS structure on the top side of the wafer in the device region, (2) forming grooves on the bottom side of the wafer in the dicing region, (3) forming a MEMS die by dicing the wafer in the z-direction along the grooves from the top side of the wafer to the bottom side of the wafer so that the bottom side of the MEMS die comprises at least one horizontal surface and at least one non-horizontal surface, (4) providing a substrate and an ASIC die. The substrate has a top side and a bottom side, and the ASIC die has a top side and a bottom side, and there is a bonding pad attached to the top side of the ASIC die. The bottom side of the ASIC die is attached to the top side of the substrate, (5) depositing an adhesive layer on the top side of the ASIC die next to the bonding pad, (6) attaching the bottom side of the MEMS die to the top side of the ASIC die via the adhesive layer so that adhesive layer extends in the z-direction from the top side of the ASIC die to the horizontal surface and along a portion of the non-horizontal surface of the MEMS die, (7) forming an electrical connection between the bonding pad and the MEMS die.

Figure 11a illustrates the first step of the method for the fabrication of the electronic component. This step comprises providing a wafer 11023. The wafer has a top side and a bottom side, and the wafer comprises a device region 11024 and a dicing region 11025. The dicing region 11025 surrounds the device region 11024 in the xy-plane. The wafer 11023 further comprises at least one MEMS structure on the top side of the wafer in the device region 11024.

Figure 11b illustrates another step of the fabrication method. This step comprises forming grooves 11126 on the bottom side of the wafer 11023 in the dicing region 11025. The grooves may be formed by Deep Reactive Ion Etching (a.k.a DRIE method). Alternatively, the grooves may be formed by wet etching, or the groves may be formed by mechanical blade dicing.

Figure 11c illustrates a further step of the fabrication method. This step comprises forming a MEMS die 1122 by dicing the wafer 11023 in the z-direction along the grooves 11126 from the top side of the wafer to the bottom side of the wafer, so that the bottom side of the MEMS die 1122 comprises at least one horizontal surface 11211 and at least one non-horizontal surface 11212. Thus, the MEMS die 1122 comprises a top part 1128 and a bottom part 1129 wherein the top part 1128 and the bottom part 1129 are contiguous with each other and are aligned along the z-direction. The non-horizontal surface 11212 extends from the horizontal surface 11211 to the top part 1128 of the MEMS die 1122.

The non-horizontal surface 11212 of the bottom part 1129 may comprise a plurality of faces wherein the angle in the xy-plane between at least one pair of adjacent faces is a right angle. Alternatively, the non-horizontal surface 11212 of the bottom part 1129 may comprise a plurality of faces wherein the angle in the xy-plane between at least one pair of adjacent faces is a non-right angle. The angle in the xy-plane between the at least one pair of adjacent faces may be an acute angle or an obtuse angle. Alternatively, the non-horizontal surface 11212 of the bottom part 1129 may be curved.

Figure 11d illustrates the step which comprises providing a substrate 1130 and an ASIC die 1131. The substrate 1130 has a top side and a bottom side, the ASIC 1131 die has a top side and a bottom side, and there is a bonding pad 1134 attached to the top side of the ASIC die 1131. The bottom side of the ASIC die 1131 is attached to the top side of the substrate 1130.

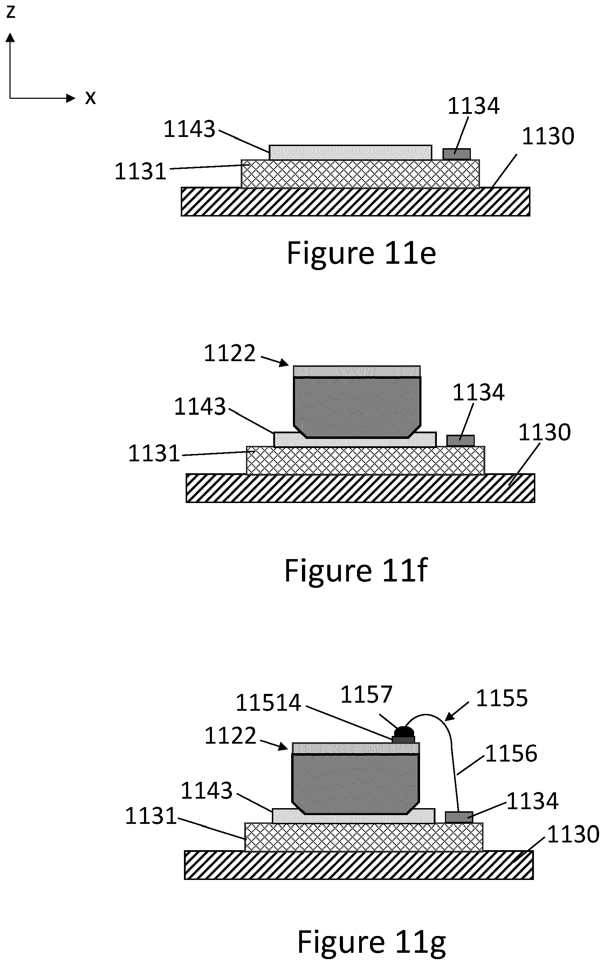

Figure 11e illustrates the step which comprises depositing an adhesive layer 1143 on the top side of the ASIC die 1131 next to the bonding pad 1134.

Figure 11f illustrates a further step of the fabrication method. This step comprises attaching the bottom side of the MEMS die 1122 to the top side of the ASIC die 1131 via the adhesive layer 1143 so that adhesive layer 1143 extends in the z-direction from the top side of the ASIC die 1131 to the horizontal surface 11211 and along a portion of the non-horizontal surface 11212 of the MEMS die.

Figure 11g illustrates the final step of the fabrication method. This step comprises forming an electrical connection 1155 wherein the electrical connection 1155 extends from the bonding pad 1134 to the top of the MEMS die 1122. The electrical connection 1155 may comprise a bonding wire 1156 and a bond ball 1157. The bond ball 1157 may be formed onto an additional bonding pad 11514 located on top of the MEMS die 1122. The bonding wire 1156 may extend from the bond ball 1157 to the bonding pad 1134. The electrical connection 1155 may be formed using wire bonding technique. Alternatively, the electrical connection may further comprise wiring layers in the substrate, so that the MEMS die is electrically coupled to the ASIC die via the substrate.

## Claims

1. An electronic component comprising:
- a substrate with a top side and a bottom side, wherein the substrate defines a horizontal xy-plane and a vertical z-direction which is perpendicular to the xy-plane,
- an ASIC die, wherein the ASIC die has a top side and a bottom side, and the bottom side of the ASIC die is attached to the top side of the substrate,
- a MEMS die, wherein the MEMS die comprises a top part and a bottom part, and the bottom part comprises at least one horizontal surface and at least one non-horizontal surface, and wherein the horizontal surface defines at least a portion of the bottom surface of the MEMS die, and wherein the top part and the bottom part of the MEMS die are contiguous with each other and are aligned along the z-direction so that the non-horizontal surface extends between the horizontal surface of the bottom part and top part,
- an adhesive layer, wherein the adhesive layer extends in the z-direction from the top side of the ASIC die to the horizontal surface and to a portion of the non-horizontal surface of the bottom part of the MEMS die,
**characterized in that**
the component further comprises a bonding pad and an electrical connection, and the bonding pad is attached to the top side of the ASIC die next to the adhesive layer, and wherein the electrical connection extends from the bonding pad to the top of the MEMS die.

2. An electronic component according to claim 1, wherein the top part of the MEMS die comprises a horizontal bottom, and wherein the non-horizontal surface of the bottom part extends from the horizontal surface of the bottom part to the horizontal bottom of the top part.

3. An electronic component according to claim 1, wherein the top part of the MEMS die comprises a side wall, and wherein the non-horizontal surface of the bottom part extends from the horizontal surface of the bottom part to the side wall of the top part.

4. An electronic component according to any of claims 1-3, wherein the non-horizontal surface of the bottom part is curved.

5. An electronic component according to any of claims 1-3, wherein the non-horizontal surface of the bottom part comprises a plurality of faces, and wherein the angle in the xy-plane between at least one pair of adjacent faces is a right angle.

6. An electronic component according to any of claims 1-3, wherein the non-horizontal surface of the bottom part comprises a plurality of faces, and wherein the angle in the xy-plane between at least one pair of adjacent faces is a non-right angle.

7. An electronic component according to claim 6, wherein the angle in the xy-plane between the at least one pair of adjacent faces is an acute angle.

8. An electronic component according to claim 6, wherein the angle in the xy-plane between the at least one pair of adjacent faces is an obtuse angle.

9. An electronic component according to any of the previous claims, wherein the bottom part comprises a plurality of horizontal surfaces, and wherein the horizontal surfaces are separated by trenches, and wherein the adhesive layer further extends in the z-direction from the top side of the ASIC die through the trenches.

10. A method for manufacturing an electronic component,
**characterized in that** the method comprises:
- Providing a wafer, wherein the wafer has a top side and a bottom side, and the wafer comprises a device region and a dicing region, wherein the dicing region surrounds the device region in the xy-plane, and wherein the wafer further comprises at least one MEMS structure on the top side of the wafer in the device region,
- Forming grooves on the bottom side of the wafer in the dicing region,
- Forming a MEMS die by dicing the wafer in the z-direction along the grooves from the top side of the wafer to the bottom side of the wafer so that the bottom side of the MEMS die comprises at least one horizontal surface and at least one non-horizontal surface,
- Providing a substrate and an ASIC die, wherein the substrate has a top side and a bottom side, and the ASIC die has a top side and a bottom side, and there is a bonding pad attached to the top side of the ASIC die, and wherein the bottom side of the ASIC die is attached to the top side of the substrate,
- Depositing an adhesive layer on the top side of the ASIC die next to the bonding pad,
- Attaching the bottom side of the MEMS die to the top side of the ASIC die via the adhesive layer so that adhesive layer extends in the z-direction from the top side of the ASIC die to the horizontal surface and along a portion of the non-horizontal surface of the MEMS die,
- Forming an electrical connection between the bonding pad and the MEMS die.

11. A method for manufacturing an electronic component according to claim 10, wherein the grooves are formed by Deep Reactive Ion Etching.

12. A method for manufacturing an electronic component according to claim 10, wherein the grooves are formed by wet etching.

13. A method for manufacturing an electronic component according to claim 10, wherein the grooves are formed by mechanical blade dicing.
